# EUROPEAN PATENT APPLICATION

(11) **EP 1 096 560 A2**
(43) Date of publication of application: **02.05.2001**
(21) Application number: 00660190.0
(22) Date of filing: 25.10.2000
(51) Int. Cl.: H01L 21/66, H01L 21/784, H01L 21/822, H01L 21/027, H01L 27/08, H01L 21/329

(54) **Method of manufacturing integrated circuits with intermediate manufacturing quality controlling measurements**

(30) Priority: 01.11.1999 FI 992361
(71) Applicant: NOKIA MOBILE PHONES LTD., 02150 Espoo (FI)
(72) Inventor: Kuiri, Tapio, 90580 Oulu (FI)
(74) Representative: Antila, Harri Jukka Tapani

(57) **Abstract**

The invention relates to a method of manufacturing integrated circuits, in which a variety of masks is used for manufacturing material layers, among which masks a suitable mask is selected to check the manufacturing quality of the component areas manufactured on the previous layer on the basis of the measurement results. Thus, the value of the component to be manufactured can be tuned to fit into the desired range and the range of the electrical values of the components of integrated circuits can be decreased. The component can be tuned in a variety of ways, e.g. by manufacturing components of different sizes and selecting a suitable component among them (158, 160, 162).

## Description

### FIELD OF THE INVENTION

The invention relates to a method of manufacturing integrated circuits.

### BACKGROUND OF THE INVENTION

Several modern electronical devices comprise integrated circuits, which in some cases are also called microcircuits. These integrated circuits have contributed to a considerable improvement in the capacity of electronical devices in the past years and decades. More and more components are packed in integrated circuits, which allows the memory and information capacities to improve. The continuous growth of the integration degree is mainly due to the fact that while the manufacturing technology has advanced, the components used in microcircuits have become smaller.

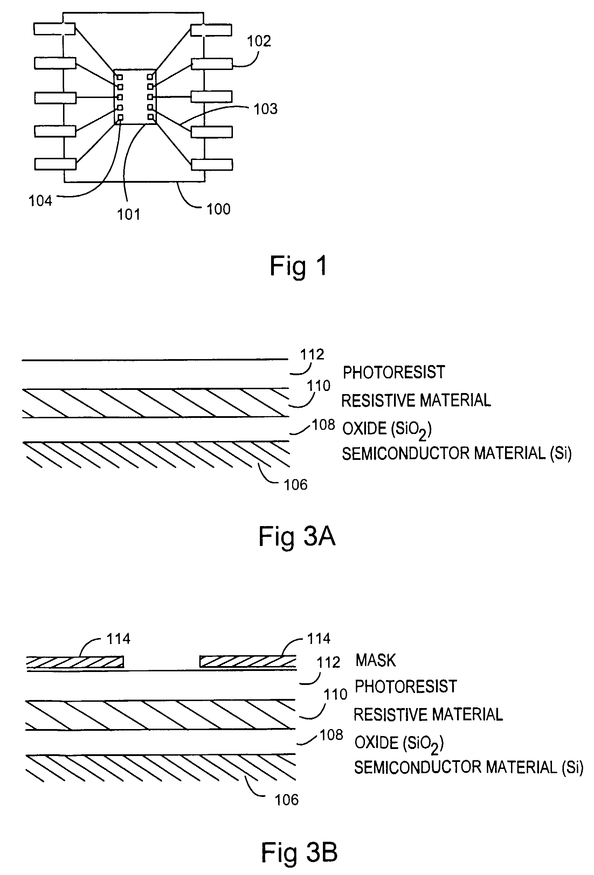

The popularity of integrated circuits is not only based on their capacity but also their competitive price, which is very much due to the efficiency of the manufacturing process. The efficiency of the manufacturing process is largely attributed to the fact that a large amount of semiconductor chips included in the microcircuits is manufactured at a time. During the manufacture of one lot of semiconductor chips the whole lot undergoes the same steps of the manufacturing process simultaneously. In the following, a typical method of manufacturing integrated circuits, the related steps and concepts are described. Figure 1 shows a simplified view of an integrated circuit. The functional parts of an integrated circuit are generally manufactured on a semiconductor chip. This chip 101 is located inside a microcircuit case 100, and the external connections are established to the pins 102 of the microcircuit. From these pins signals and operating voltages are supplied to the components on the chip. The electrical connection between the pins in the microcircuit case and the functional parts on the chip is established by combining the pins with bonding pads 104 on the chip by means of bonding wire 103. The chips may also be directly connected with other electronics e.g. by a so-called flip-chip method, or they can be bonded onto the circuit board among the other components. Together with the external electronics, a microcircuit or a group of microcircuits forms a functional entity.

Semiconductor chips are made of semiconductor wafers sawn from a semiconductor bar. One semiconductor wafer generally comprises hundreds or even thousands of separate chips. Chips are detached from the wafers and combined with other electronics. Before the detachment, the chips are handled at various stages to manufacture components. This manufacturing process is described later. Generally wafers are handled in production lots, a production lot comprising several wafers. There may thus be as many as hundreds of thousands of separate semiconductor chips in one production lot. One chip may comprise electric components (devices) from a few components to as many as millions of components. The manufacturing accuracy regarding the electrical properties of these components is usually good, if they are compared inside the production lot, but remarkably bad, if the same type of components are compared between different manufacturing lots.

Figure 2 illustrates how the manufacturing accuracy relating to the electrical properties of the components varies. Components 124 on the same semiconductor chip are very similar, whereas components on the chips 126 detached from the same semiconductor wafer differ a bit more from one another due to longer distance on the wafer. The reason why the distance affects this way is that treatments of the manufacturing process have a slightly different effect on different parts of the wafer. The effect of some treatments is comparable to the distance from the centre of the wafer. Most treatments, however, vary more or less randomly. For example, if wafers are subjected to a gas, turbulences in the gas affect the gas dose obtained by components at different locations. Similarly due to a greater distance, components on different wafers 128 differ from one another more than components on the same wafer. These variations, too, are typically considerably smaller than variations between different production lots.

Wide variations between production lots result from the fact that the treatments differ slightly from one another at different manufacturing times. Treatments are naturally kept as similar as possible, but as the used methods are very sensitive to e.g. temperature changes, slight differences always occur. In addition, raw materials and the like may include manufacturing variations, wherefore the components to be manufactured differ from one another.

Most of the semiconductor chips to be manufactured must principally be accepted in the production of integrated circuits. If too strict limits are set to the electrical values, the yield of chips deteriorates too much. The processing limits are generally set relatively wide compared with the variations of a normal production lot to ensure that the yield is not endangered, although the treatments of the production would include the above variations or the like. This means that value tolerances regarding the manufacturing accuracy are often set too wide for circuit planning. The related problems are described later.

In the following, treatments of a semiconductor wafer are described, in which the components and the wirings connecting them are manufactured on the semiconductor chips on the wafer. The descriptions of the treatments do not cover all the methods to be used nor very specific details.

The manufacturing process can be divided into two stages, in the first of which the actual components are manufactured and in the latter the wirings are made between these components. This division is not very strict, and for example some component parts can be used simultaneously as part of the wiring.

Components are manufactured both onto a substrate formed by a semiconductor wafer or onto layers processed on top of the substrate. In some cases, the component may be regarded as consisting of the parts in the substrate and the parts arranged in layers. The conductivity of an untreated semiconductor wafer is typically poor. Conductivity can be affected by doping more impurity atoms to the semiconductor. These impurity atoms bring more free carriers which improve the conductivity. Generally two types of impurity atoms are used, some of which improve the N-type conductivity, others the P-type conductivity. In different components, different impurity atom contents are typically used, and/or the different parts of the same component can have different contents. Thus, the desired properties are provided in the components. Many of the semiconductor components are based on PN junctions, which are formed between the component areas precipitated with different types of impurities. Essential for the manufacturing accuracy of the components based on a PN junction are the amount of impurities, content profile, the size of the junction etc.

Impurities can be brought onto the semiconductor wafer in a variety of ways. Firstly, in the manufacture of wafers some impurity atoms are added to the semiconductor bar to be processed, from which the wafers are cut. The basic conductivity and conductivity type of the wafer are determined at this stage. Further, if more semi-conducting material is processed onto the surface of the wafer, the amount and type of the conductivity of the material can be adjusted during processing. In addition, impurity atoms can be "shot" to a desired depth in the wafer by ion implantation. A widely used method is also diffusion, which allows the impurities to penetrate into a semiconductor material. Various methods can naturally be used together or apart to manufacture the desired components and to create the desired properties for them. For example, ion-implanted impurities can be spread to a wider area with a diffusing heat treatment.

Some components are manufactured by layering conducting and insulating layers one on the other at subsequent stages. Usually the insulating layer needs to be made as insulating as possible, and the conductivity of the conducting layers is made suitable by regulating the amount of impurity atoms. The conductivity can be regulated by the above methods. In some cases, e.g. in a plate capacitor, the component comprises both conducting and insulating layers.

One manufacturing stage often serves many types of components. For example, the gate of a MOSFET transistor can be made of the same material as the resistors. This way manufacturing stages can be minimised and the costs can be decreased.

The manufactured components are connected with each other by means of metal layers usually formed at the final stage of manufacture. Generally the first metal layer establishes an electrical connection to previously manufactured components. There can be several metal layers, between which there are insulating layers. Different metal layers are joined together by via layers. On top of the last metal layer, a passivation layer is normally formed, which is provided with openings for interfaces to connect with the outside world.

What is common to all the above stages is that each treatment is directed only to specific parts of the semiconductor wafer. Only seldom the treatment is directed to the whole wafer regardless of the location. By directing the treatment, the desired components are formed at exactly the desired locations on the semiconductor chips. The surface of the wafers needs thus be patterned such that the desired treatment is only directed to the planned locations on the wafer. The semiconductor chips to be manufactured at different locations of the wafer are typically identical according to the prior art.

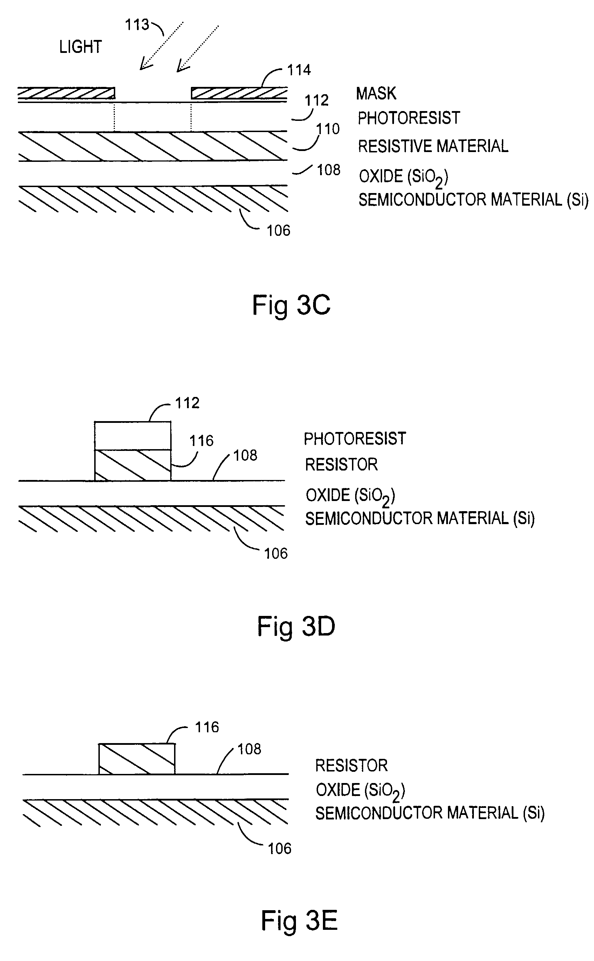

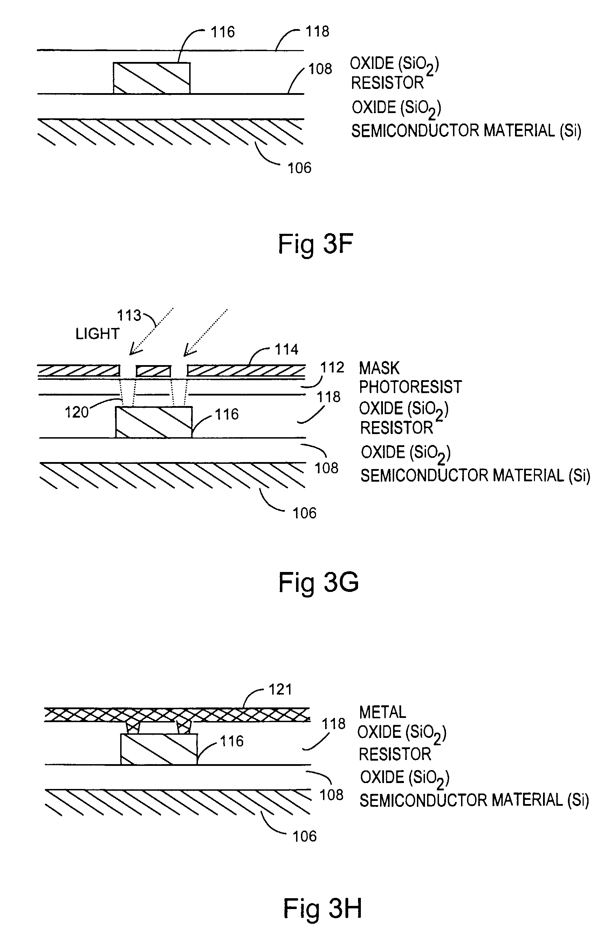

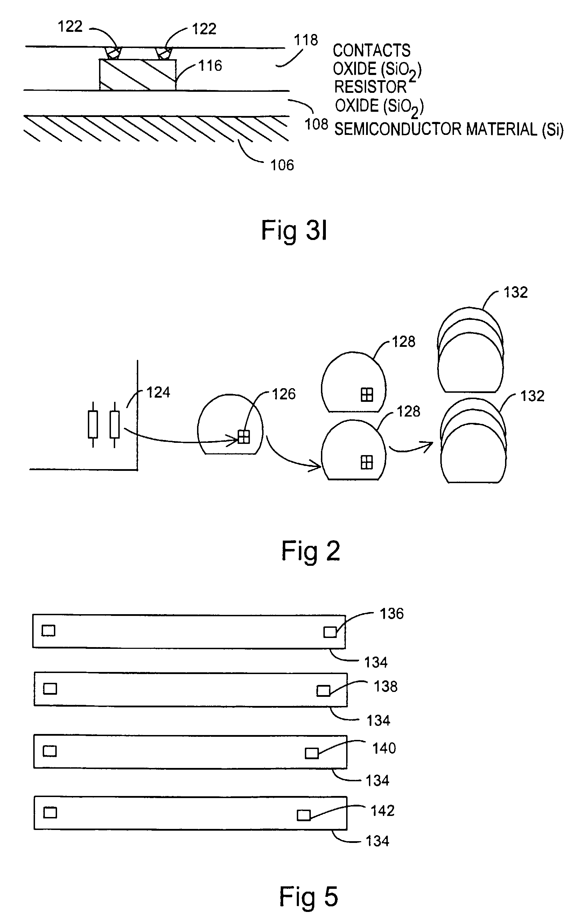

So-called photolithography, illustrated in Figures 3a to 3i, is generally used for patterning. In Figure 3a, 106 illustrates a semiconductor wafer and 108 oxide formed on its surface. Before patterning, the whole wafer is typically coated with some material e.g. by sputtering or processing. In Figure 3a, the material to be patterned 110 is resistive to create resistance. In photolithography, material sensitive to light (photoresist) 112 is spread onto the surface to be patterned, and part of this material is exposed. Mask 114, Figure 3b, is used to crop the desired spots. A mask is a plate with sections of desired size and shape that are permeable to light. When subjected to light, 113 in Figure 3c, the material sensitive to light hardens so that after the exposure, a chemical etching the photoresist etches only that part of the photoresist that remained unexposed. In an alternative method, the photoresist is only etched from the exposed sections, whereby the patterning of the mask should naturally be a negative. The patterning determines to which sections material is to be left. After patterning, the material to be handled is etched away from all the other sections but those where the photoresist hinders the effect of the etching substance. In Figure 3d, 116 illustrates a resistor to be manufactured and 112 a photoresist protecting it. After etching the material, the hardened photoresist is removed with a substance which does not remove the resistive material, Figure 3e. Thereafter, conducting contacts are made for the component by plating the frame section of the component with silicon dioxide 118, Figure 3f. Then, in Figure 3g, holes 120 are formed into desired sections in the silicon dioxide layer 118 by exposing the photoresist 112 through the sections of the mask 114 permeable to light, after which the photoresist and oxide are removed from the holes. After the rest of the photoresist has been removed, the holes are filled with metal, Figure 3h. Thereafter, the excess metal is removed e.g. by etching. Figure 3i shows a complete component with its contacts. Via layers and the following metal layers are manufactured in the corresponding manner.

10 to 30 different masks are typically used in patternings of integrated circuits. The number of masks depends on the structure of the components to be manufactured, the amount of various components etc. Some components require many different masks in their manufacture, others need only one. All components of the same type are manufactured at one time, by the same treatments. However, it is to be noted that e.g. resistors can be made of various materials and by treating in various ways, and thus different types of resistors need different masks.

By far the widest used method of patterning at the moment is the photolithographical method described above. The problem of the photolithographical method is a fairly long wave length of light, which partly determines the smallest possible size of the pattern. Alternative methods of patterning are e.g. X-ray lithography or E-beam lithography, but they are not yet in common use. Photolithographical methods, which are particularly suitable for mass production, have constantly improved, and they meet the requirements set by the development of the component closeness.

A disadvantage of the prior art is a poor manufacturing accuracy of the components to be manufactured. This is due to e.g. variations in the quality of materials and in the size and shape of the components: the components to be etched may etch too much or too little. Furthermore, the thicknesses of the material layers to be manufactured may vary. The variations in impurity atom contents may make their own contribution to the accuracy of the general manufacture.

At its worst, a poor manufacturing accuracy decreases the yield of integrated circuits, if the processing limits are set too narrow. On the other hand, if wide variations are allowed in the production of circuits, it usually causes problems for the user of the circuits. The yield deteriorates in the production of an apparatus using the circuits. Alternatively, wide variations may be taken into account when planning these apparatuses, or the operation of the circuits can be tuned in the production. Wide variations may also then cause additional power consumption and increased costs in form of a bigger size of a semiconductor chip and additional production costs, as the turnaround time of the production increases. In some cases, wide variations simply hinder the integration of the desired component or components. Due to the manufacturing accuracy, the medium frequency of a resonator with a big Q value, for instance, may vary so much that the desired frequency is no longer on the pass band of the resonator. The Q value of the resonator must then be decreased or the integration has to be given up. Some RF components require a relatively accurate adaptation to operate in the desired manner. In some cases, the integration of these adaptation components is impossible due to poor manufacturing accuracy.

### BRIEF DESCRIPTION OF THE INVENTION

The object of the solution of the invention is to provide a desired electrical value range in the production of the components of integrated circuits in a more precise way. This is achieved by the methods described below. The invention relates to a method of manufacturing integrated circuits, in which method materials are manufactured onto a basic material by layering at least two layers by means of patterning, and before manufacturing the last material layer, performing one or more verifying measurements from at least one quantity, which describes the manufacturing quality of one or more component areas manufactured in the previous layer by patterning, selecting for the manufacture of the next material layer a suitable patterning on the basis of verifying measurement results obtained from the previous layer.

The invention also relates to another method of manufacturing integrated circuits, in which method at least two layers are manufactured by means of patterning by changing electrical properties of one or more areas of a basic material and by layering materials, and before manufacturing the last material layer, performing one or more verifying measurements from at least one quantity which describes the manufacturing quality of one or more component areas manufactured in the previous layer by patterning, selecting for the manufacture of the next material layer a suitable patterning on the basis of verifying measurement results obtained from the previous layer.

The invention further relates to an integrated circuit comprising components manufactured by layering materials on a basic material, which components are adapted at the layering stages to reach the desired value ranges of electrical values, and this value range adaptation is implemented by selecting a suitable patterning alternative. For selecting a patterning alternative, one or more verifying measurements are performed before the last material layer is manufactured, and the verifying measurements are performed from at least one quantity describing the manufacturing quality of one or more component areas manufactured by patterning.

The invention further relates to an integrated circuit comprising components manufactured by changing the electric charge of a specific area of a basic material and by layering materials, which components are adapted at the layering stages to reach the desired value ranges of electrical values, and this value range adaptation is implemented by selecting a suitable patterning alternative. For selceting a patterning alternative, one or more verifying measurements are performed before the last material layer is manufactured, and the verifying measurements are performed from at least one quantity describing the manufacturing quality of one or more component areas manufactured by patterning.

The preferred embodiments of the invention are disclosed in the dependent claims.

The method of the invention provides a plurality of advantages. The manufacture of apparatuses with integrated circuits saves costs, because integrated circuits need not be tuned to correspond the determined values. In addition, in some cases the tuning is not possible in practice, so the amount of nonmarketable products decreases. The time that products spend on the production line decreases as well. Time is saved in the planning of integrated circuits, as tuning possibilities do not need to be taken into account e.g. by adding resistors, among which a resistor is selected by a switch. The apparatus itself can thus be planned as having a smaller size and the power consumption of the apparatus can be decreased, which are essentially important factors especially when portable devices are concerned. Furthermore, as the range of the electrical values of the components is smaller, the Q value of the resonance circuits can be increased at the planning stage, more accurate RF adaptations can be performed etc. The method of the invention may also improve the yield of the industry manufacturing semiconductor components.

### BRIEF DESCRIPTION OF FIGURES

In the following the invention will be described in greater detail in connection with the preferred embodiments with reference to the attached drawings, in which:
Figure 1 shows one case type of integrated circuits as described above;
Figure 2 illustrates the variation of the range of the electrical values of integrated circuit components, as described above;
Figures 3a to 3i show a layer-like structure of integrated circuits at different manufacturing stages, as described above;
Figure 4 shows a flow chart of the method of the invention;
Figure 5 illustrates the tuning of a resistor by changing the locations of contacts;
Figures 6a to 6c illustrate the tuning of a resistor by manufacturing a wiring to a contact at different location;
Figures 7a to 7c illustrate the tuning of a resistor by manufacturing components of different sizes by means of masks and selecting a suitable component among them;
Figures 8a to 8b illustrate the tuning of a resistor by manufacturing components of different sizes by means of masks and connecting them suitably with each other;
Figure 9 illustrates the tuning of a resistor by manufacturing components of the same size by means of masks and connecting them suitably with each other, and
Figures 10 a to 10b illustrate the tuning of a resistor by changing the length of the resistor frame by adjusting the size of a more conducting or insulating area by means of a mask.

### DETAILED DESCRIPTION OF THE INVENTION

The basic idea of the method of the invention is to measure the electrical properties of the components to be manufactured or the quantities affecting them during the manufacturing process and to change the following manufacturing stages or the tools used in the manufacture so that the electrical properties of the manufactured components approach to the values planned for them. This can be done easily by changing the patterning of the components or that of the wirings connecting them. This way the value range of the electrical properties of the components can be reduced. Here, it deals with the tuning of electrical values.

In the following, the manufacture of a typical integrated semiconductor circuit is described by means of the method of a preferred embodiment of the invention. The method of the invention is described by means of resistors to be manufactured on a semiconductor wafer, but it is to be noted that the invented method can be applied to the improvement in the manufacturing accuracy of all types of integrated circuit components. The method is thus also applicable to the improvement in the manufacturing accuracy of thin-film and thick-film circuits and the improvement in the SOI (Silicon on insulator) type of integrated circuits manufactured onto an insulating substrate, if the manufactured components or parts of them can be measured, and the stages of operation performed after the measurements can be changed on the basis of the measurements.

In the method of the invention of producing integrated circuits, the manufacturing accuracy can be improved up to the level corresponding to the manufacturing accuracy inside a semiconductor wafer or a corresponding entity. Furthermore, potential known manufacturing variations inside a wafer can be corrected in a preferred embodiment of the manufacturing method of the invention.

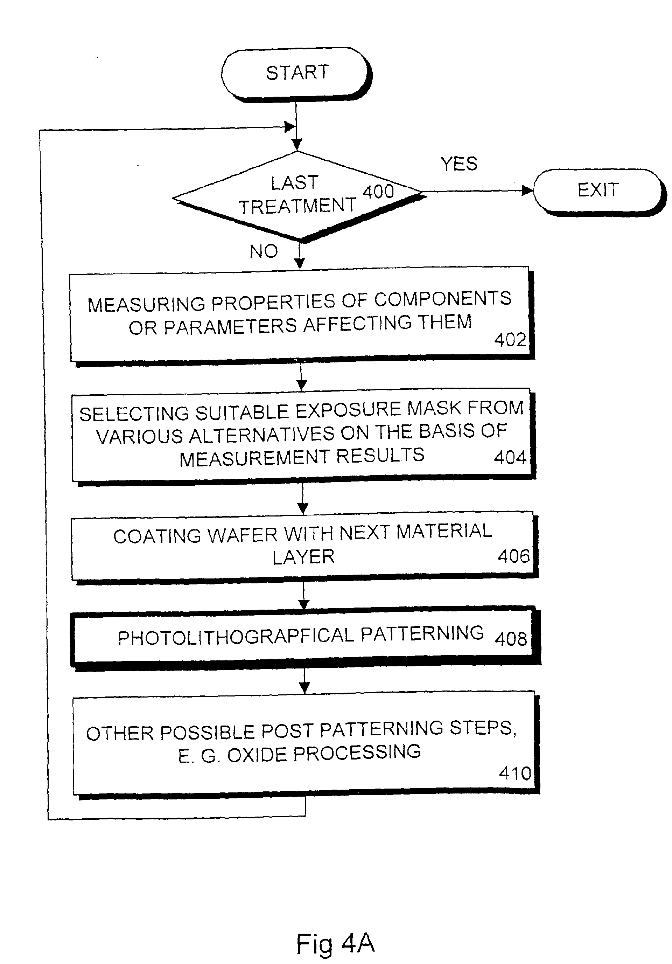

Figure 4a illustrates the method of the invention by means of a flow chart. In the first step a set of components or parts of them are manufactured according to the prior art. Next, the electrical or other properties 402 of the manufactured components or of the materials used in them are measured. Thus, a desired electrical property of a specific component or component type can be measured directly, or indirectly, whereby other properties of a component type affecting the electrical properties of components are measured. The dimensions of a material, for example, signify indirectly also electrical properties. Sometimes manufacturing conditions, such as temperature, pressure etc., during the manufacture of the component can also be measured.

If possible, it is reasonable to combine the measurements according to the invention with the measurements used in the inspection of the quality of manufacture, but if required, more measurements can be performed. Normally, separate test structures and test components are added onto the semiconductor wafer among the actual desired semiconductor chips. These test structures are measured at different stages of manufacture, whereby it can be ensured that the previous stages have been successfully performed before the next stages are started. Results of these measurements can be utilized in the method of the invention. It is preferable to select the test structures in such a manner that the components used in the actual connections correspond to the test components as well as possible. The measurement results of the test structures correlate then as well as possible with the electrical properties of the components used in the connections.

Measurements do not necessarily need to be concentrated exactly on the components used in the connections of semiconductor chips, but also the same type of components on the same wafer can be measured. This is because the properties of the same type of components do not usually vary much inside the wafer. Naturally, several measurements can be made and at several different stages. The measurements can further be electric, optic etc.

At the next step a desired mask is selected on the basis of measurement results 404. To manufacture a certain component type or material layer there are usually specific masks to be used. Same kinds of masks are used for each wafer. In the method of the invention there are several alternatives for masks. One of these mask alternatives is used for each wafer.

If the electrical properties of the components to be manufactured do not differ too much from one another within one manufacturing lot including several wafers, the same mask can be selected for all wafers within the same lot.

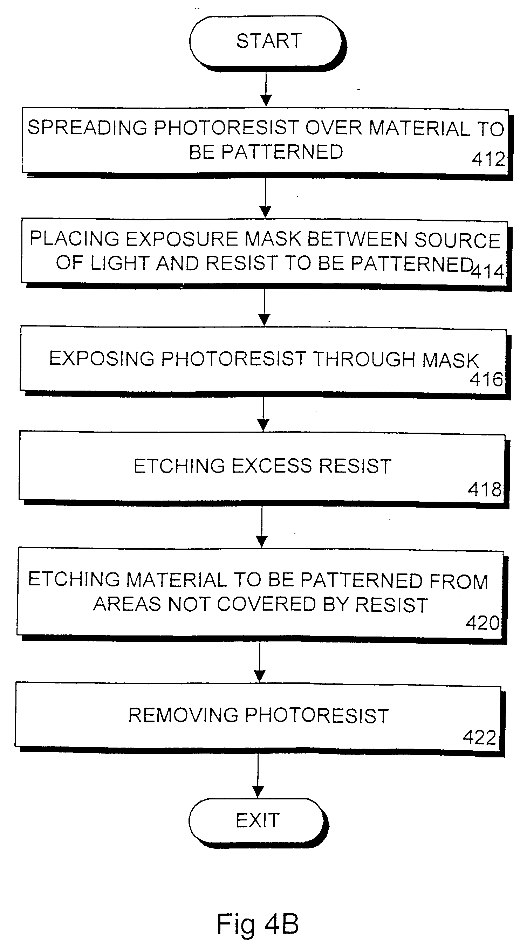

At step 406 the semiconductor wafer is coated with the next material layer, e.g. metal, after which the material is patterned according to the photolithographical method described above, step 408. Figure 4b is a simplified flow chart of the photolithographical method of patterning. In the method, a photoresist is spread over the material to be patterned 412, the exposure mask selected for the patterning is placed between a source of light and the photoresist 414, the exposure is performed 416, the excess resist is etched 418, the excess of the material to be patterned is etched in accordance with the desired patterning 420 and the rest of the photoresist is removed 422. Figure 4a shows that other steps may be performed after this, such as oxide growing 410. The method of the invention is repeated in the patterning of desired layers during the manufacturing process, until the last layer is finished 400.

The method of the invention can be applied in various ways to improve the value ranges of the electrical properties of the components. In the following, some alternatives are described by way of example for improving the manufacturing accuracy of the resistance of a resistor.

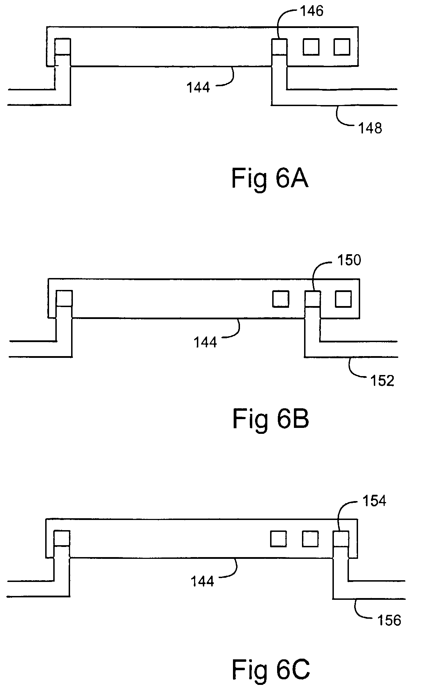

Figure 5 shows resistors in which the contacts of the resistors are at different locations on the rectangle made of resistor material. The resistance of a rectangle-shaped resistor is mainly determined by dividing the length of the resistor, i.e. the distance between the contacts, by the width of the resistor, which is the dimension of the resistor perpendicular to the length, and by multiplying by so-called square resistance. Thus, the resistance of the resistor can be changed by changing the locations of the contacts on the surface of the resistor. Square resistance is determined on the basis of the resistivity and thickness of the material.

Rectangles in Figure 5 can thus be regarded as being the same resistor component 134, but on a different semiconductor wafer. Different masks are used on different wafers to manufacture the contacts 136, 138, 140 and 142 at different locations. The method of changing the locations of contacts requires that the electrical properties of the component are either directly or indirectly measured before the mask determining the location of contacts is selected.

Figures 6a, 6b and 6c show a resistor 144, to the other end of which several contacts 146, 150 and 154 are manufactured. The mask used in the patterning of the upper wiring layer is selected so that it is only in contact with one of the above mentioned contacts. In Figure 6a, wiring 148 is selected to contact the contact 146, as the previous measurement result has indicated the resistance of the resistors on the wafer in question to be too high compared with the planned value. By changing the wiring 148, the resistor has been made shorter and the resistance value has been decreased nearer to the desired value. In Figure 6b, wiring 152 is selected to contact the contact 150, as the measurements have indicated the resistance values to be very near to the planned values. In Figure 6c, wiring 156 is selected to contact the contact 154, which is located furthest from the contact at the other end of the resistor. This way the resistance value has been increased after the previous measurement results indicated the value to be too small.

It is to be noted that the resistor can also have some other shape than a rectangle, which is selected for the figure only because it is most commonly used and it is illustrative. The metal layer used in the wiring does not necessarily have to be the first metal layer that is formed after the contacts, but it can also be any other following layer. For example, the choice can also be made such that the actual via layers that are used for the wiring and that combine the metal layers are alternatively patterned in such a manner that the wiring layers themselves remain the same.

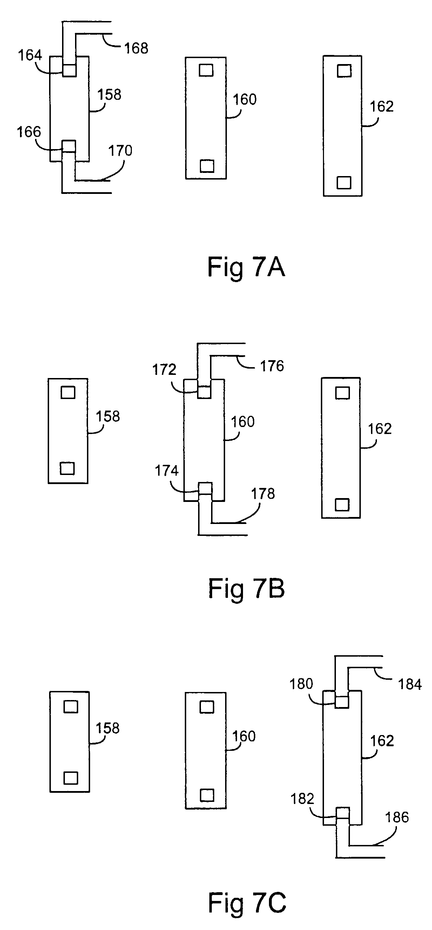

Figures 7a, 7b and 7c show a preferred embodiment of the invention. Each of the above mentioned figures comprises three resistors 158, 160 and 162 of different sizes. Wirings 168, 170, 176, 178, 184 and 186 connecting the resistor to other components are in Figures 7a, 7b and 7c alternatively selected to contact a different resistor on the basis of the measurement results. The manufactured contacts are illustrated by 164, 166, 172, 174, 180 and 182. When the resistance values are too small, too big or typical, the biggest resistor 7b, the smallest resistor 7c or the medium resistor 7a is alternatively selected for use.

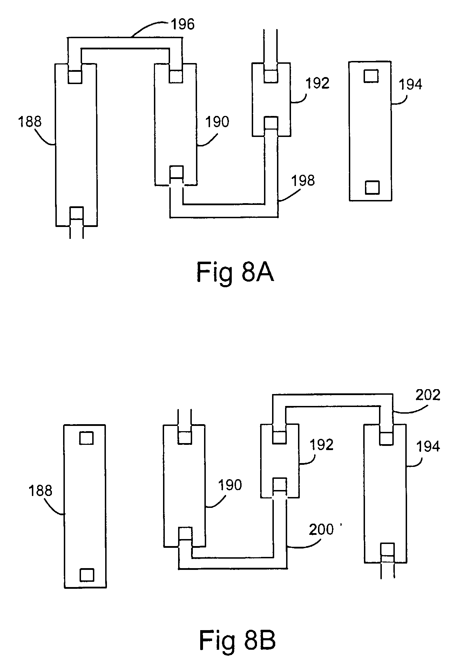

If resistors are big, the manufacture of alternative components is not necessarily the most cost-efficient alternative. Therefore, Figures 8a and 8b show another preferred embodiment of the invention, in which the desired resistance is achieved by connecting resistors of various sizes in series. In Figure 8a, the total resistance value of the resistors connected in series is bigger than that of the series connection in Figure 8b, as the resistor 188 is longer than the resistor 194. The resistors 190 and 192 are common to both series connections and do not affect the order of total resistance values. A series connection could naturally have been arranged by the components 188, 190, 192 and 194 also in other way.

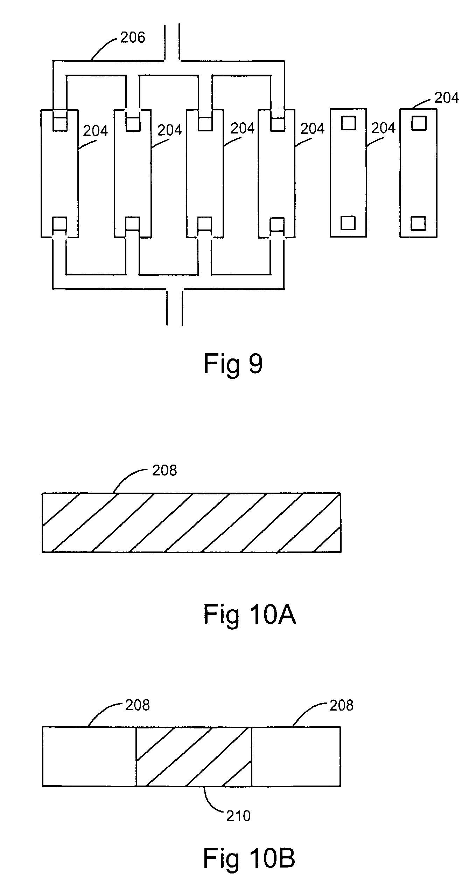

Furthermore, it is obvious that the desired total resistance value can also be obtained by connecting separate resistor components in parallel or by combining series and parallel connections. Figure 9 shows resistors 204 of the same size connected in parallel, whereby a suitable amount of resistors are connected 206 on the basis of measurement results so that the total resistance of the connection in parallel approaches to the planned value as close as possible.

Figures 10a and 10b show a rectangular resistor. The square resistance of the rectangle in Figure 10a is relatively high. In Figure 10b the square resistance of the resistor ends is decreased by improving conductivity with impurity atoms. Thus, the actual resistor forms in the area 210, whose dimensions and square resistance determine the resistance value. The wirings are connected to the areas 208 at the ends of the resistors. The length of the area 210 is determined in such a manner that the effect of impurity atoms on that area is prevented. The method of the invention can be applied by changing the size of the patterning by selecting a suitable mask from various alternatives.

In the previous examples, the alternative connections are selected from two or three alternatives. The number of alternatives affects the accuracy of tuning, e.g. when the original variation range is +/-20 per cent, it can be reduced to +/-5 per cent with four alternatives. The best possible manufacturing accuracy is limited by the internal variation of one semiconductor wafer. This is because in the solution of the preferred embodiment of the invention, one wafer is tuned at a time in such a manner that the mean value of the electrical property is measured from the wafer and the tuning is performed on that basis. The electrical value deviations of the components on the different chips of the wafer from the mean value of the measurement results cannot thus be corrected by this method.

In some cases, the method of the invention can be applied so that the manufacturing variations of various types of components are corrected by tuning only one type of components. This can be done e.g. in some RC circuits in which the electrical properties depend on the product R times C. If both types of components, resistors R and capacitors C, include manufacturing variations, it is enough that the other type of component is tuned so that a desired product R*C is achieved.

If known and customary manufacturing variations occur on the wafer, they can be compensated in a preferred embodiment of the invention. Then, the mask alternatives used in the patterning do not only differ from one another, but also the masks or mask parts used in the patterning of different parts of the semiconductor wafer differ from one another.

In a preferred embodiment of the invention, a mask which is smaller than the semiconductor wafer and which can only be applied to the manufacture of one or more chips, is used. In this method, the semiconductor wafer is exposed by moving the selected mask to desired locations on the wafer. During the manufacturing process verifying measurements can be performed from different areas of the semiconductor wafer, and the electrical values of the components can even be tuned chip by chip by selecting a suitable mask.

Preferred embodiments of the invention can be combined e.g. by connecting a different amount of components in series and selecting a suitable contact alternative. The electrical values of the components can further be tuned at several different stages so that one mask is selected for coarse tuning and the other for fine tuning. For example, if there are 16 possible alternatives, it is preferable to perform coarse tuning by selecting from four alternatives and at the next step to perform fine tuning by selecting again from four alternatives. The first selection may concern the first wiring layer, for instance, and the second selection the following via layer. Four times four, i.e. sixteen, different combinations in all can be made in these selections, but only 4+4, i.e. 8, different mask alternatives are needed.

Dividing the alternatives between different steps is especially to be recommended when the various types of components on the same wafer need to be tuned. So if e.g. two types of resistors or resistors and capacitors need to be tuned, it is preferable to divide the tuning between as many layers as possible. If all components are tuned on one and the same layer, the number of mask alternatives of separate component types should be multiplied by one another. For example, if one type of resistor has 8 mask alternatives and the other type has 6, 48 different alternatives are needed to tune both types of resistors independently of each other. Instead, 4+6 masks are enough when the tunings are performed in two different layers.

The method of manufacturing integrated circuits according to the invention by means of resistors manufactured on a semiconductor wafer is described above. The method of the invention is independent of the basic material used in the semiconductor process and it is not only restricted to a resistor, which is used as an example for the sake of simplicity and clarity. The method can also be used in other manufacturing processes of semiconductor components and not only in the layering method of materials described for the sake of simplicity. The method is also applicable to other processes in which layers are formed on the basic material by means of masks, e.g. to the manufacture of components on a ceramic basic material. Further, the method is applicable to other methods of patterning, e.g. X-ray lithography or E-beam lithography. The method of the invention can be applied to other manufacturing methods of integrated circuits as well, e.g. to the manufacture of thin-film and thick-film circuits. A precondition for the method of the invention is that the electric properties or the parameters affecting the electrical properties of the components, or parts of the components, made at the previous manufacturing stages are measured and that the following manufacturing stages are changed so that the manufacturing accuracy of the components is improved by selecting a suitable patterning alternative for one or more of the following manufacturing stages.

Although the invention has been described above with reference to the example according to the attached drawings, it is obvious that the invention is not restricted thereto, but may be modified in a variety of ways within the scope of the inventive idea disclosed in the attached claims.

## Claims

1. A method of manufacturing integrated circuits, in which method:
materials are manufactured onto a basic material by layering at least two layers by means of patterning
**characterized** by
before manufacturing the last material layer, performing one or more verifying measurements from at least one quantity, which describes the manufacturing quality of one or more component areas manufactured in the previous layer by patterning;
selecting for the manufacture of the next material layer a suitable patterning on the basis of verifying measurement results obtained from the previous layer.

2. A method of manufacturing integrated circuits, in which method:
at least two layers are manufactured by means of patterning by changing electrical properties of one or more areas of a basic material and by layering materials,
**characterized** by
before manufacturing the last material layer, performing one or more verifying measurements from at least one quantity which describes the manufacturing quality of one or more component areas manufactured in the previous layer by patterning;
selecting for the manufacture of the next material layer a suitable patterning on the basis of verifying measurement results obtained from the previous layer.

3. A method as claimed in claim 1 or 2, **characterized** by concentrating verifying measurements on the manufactured component area.

4. A method as claimed in claim 1 or 2, **characterized** by concentrating verifying measurements on the manufacturing process of the component.

5. A method as claimed in claim 1 or 2, **characterized** by implementing the patterning by means of masks (114).

6. A method as claimed in claim 1 or 2, **characterized** by the basic material being a semiconductor.

7. A method as claimed in claim 1 or 2, **characterized** by the basic material being ceramic material.

8. A method as claimed in claim 1 or 2, **characterized** by the basic material comprising semiconductor layers and insulating layers.

9. A method as claimed in claim 5, **characterized** by using different masks to determine the location of the contacts (136, 138, 140, 142) of the component.

10. A method as claimed in claim 5, **characterized** by using different masks to manufacture suitable wiring.

11. A method as claimed in claim 5, **characterized** by using different masks to manufacture various contacts (146, 150, 154) or wirings or various components (158, 160, 162) of different sizes and selecting one or more of them.

12. A method as claimed in claim 5, **characterized** by manufacturing components (188, 192, 194) of different sizes and using various masks (114) to connect a suitable amount of them in a suitable manner (196, 198, 200, 202).

13. A method as claimed in claim 5, **characterized** by manufacturing several components of the same size and using different masks (114) to connect a suitable amount of them in a suitable manner (204, 206).

14. A method as claimed in claim 5, **characterized** by using different masks to change the resistance of the resistor component by changing the electrical properties of the frame section of the resistor component (208, 210).

15. A method as claimed in claim 5, **characterized** by achieving the desired value range of the electrical values of the component on one or more layers in stages during the manufacturing process by using suitable masks.

16. A method as claimed in claim 5, **characterized** by the mask used to pattern a semiconductor wafer being different for the components manufactured to the centre or to the edges of the semiconductor wafer, which compensates the manufacturing variations caused by the manufacture.

17. A method as claimed in claim 5, **characterized** by measuring different types of components when the circuit to be manufactured comprises various types of components, but using the mask only for the correction of one type of components.

18. A method as claimed in claim 5, **characterized** by using a mask, which is smaller than the semiconductor wafer and which directs to one or more chips (101), exposing the semiconductor wafer parts comprising one or more chips by moving the mask, selecting a suitable mask for each part of the semiconductor wafer on the basis of the measurement results.

19. An integrated circuit comprising:
components manufactured by layering materials on a basic material,
**characterized** in that
components are adapted at the layering stages to reach the desired value ranges of electrical values, and this value range adaptation is implemented by selecting a suitable patterning alternative;
for selecting a patterning alternative, one or more verifying measurements are performed before the last material layer is manufactured;
the verifying measurements are performed from at least one quantity describing the manufacturing quality of one or more component areas manufactured by patterning.

20. An integrated circuit comprising:
components manufactured by changing the electric charge of a specific area of a basic material and by layering materials
**characterized** in that
components are adapted at the layering stages to reach the desired value ranges of electrical values, and this value range adaptation is implemented by selecting a suitable patterning alternative;
for selecting a patterning alternative, one or more verifying measurements are performed before the last material layer is manufactured;
the verifying measurements are performed from at least one quantity describing the manufacturing quality of one or more component areas manufactured by patterning.
